# EUROPEAN PATENT APPLICATION

(11) **EP 1 894 952 A1**
(43) Date of publication of application: **05.03.2008**
(21) Application number: 07016855.4
(22) Date of filing: 28.08.2007
(51) Int. Cl.: C08F 290/06, C08K 5/50, C08L 51/00, C09D 133/06, C09D 151/00

(54) **Photosensitive resin composition for flexible circuit board and flexible circuit board using the same**

(30) Priority: 30.08.2006 JP 2006234137; 10.07.2007 JP 2007180839
(71) Applicant: NITTO DENKO CORPORATION, Ibaraki-shi, Osaka 567-8680 (JP)
(72) Inventor: Fujii, Hirofumi, Ibaraki-shi Osaka 567-8680 (JP); Morita, Kosuke, Ibaraki-shi Osaka 567-8680 (JP); Mizutani, Masaki, Ibaraki-shi Osaka 567-8680 (JP); Ookawa, Tadao, Ibaraki-shi Osaka 567-8680 (JP); Yoshimi, Takeshi, Ibaraki-shi Osaka 567-8680 (JP); Tada, Kouichirou, Ibaraki-shi Osaka 567-8680 (JP); Ohnishi, Kenji, Ibaraki-shi Osaka 567-8680 (JP)
(74) Representative: Kuhnen & Wacker

(57) **Abstract**

A photosensitive resin composition for a flexible circuit board capable of suppressing warpage occurrence after heat curing, and a flexible circuit board obtained by using the same. The photosensitive resin composition includes
(A) a carboxyl-group containing linear polymer having a glass transition temperature of not more than 55 °C obtained by addition polymerizing an ethylenic unsaturated compound;
(B) a polymerizable compound containing an ethylenic unsaturated group; and
(C) a photopolymerization initiator.

## Description

### BACKGROUND OF THE INVENTION

### Field of the Invention

The present invention relates to a photosensitive resin composition for a flexible circuit board ("photosensitive resin composition", hereinafter) and a flexible circuit board having a solder resist obtained by using the same.

### BACKGROUND OF THE INVENTION

In a flexible circuit board on which an electronic component such as a semiconductor element is mounted by soldering, an insulating cover layer (containing a solder resist layer) is generally provided on a conductive pattern. For example, a polyimide film, on which an adhesive layer called a cover lay is formed, is punched out at a specified shape and the thus obtained film is attached to a conductive pattern. Or, a heat-resistant material (a so-called solder resist) is attached to a required portion of a conductive pattern by a screen printing or an exposure and development method.

Solder temperature resistance, insulation properties and flame retardance in component mounting by soldering and a warpage-inhibition property of the flexible circuit board are required for such a flexible circuit board.

As a material for forming the insulating cover layer, liquid photosensitive resist materials are conventionally proposed, which are, for example, mainly composed of a bisphenol A based epoxy resin, a bisphenol F based epoxy resin and a novolak based epoxy resin (see Unexamined Japanese Patent Publication Nos. 7-207211, 8-134390 and 9-5997).

However, the liquid photosensitive resist materials mainly composed of epoxy resins such as a bisphenol A based epoxy resin, a bisphenol F based epoxy resin and a novolak based epoxy resin have the problem of warpage occurrence in the resulting flexible circuit board due to curing shrinkage of the epoxy resin after heat curing.

### SUMMARY OF THE INVENTION

It is therefore an object of the present invention to provide a photosensitive resin composition for a flexible circuit board capable of suppressing warpage occurrence after heat curing, and a flexible circuit board obtained by using the same.

A first aspect of the present invention is a photosensitive resin composition for a flexible circuit board including:
(A) a carboxyl-group containing linear polymer having a glass transition temperature of not more than 55 °C obtained by addition polymerizing an ethylenic unsaturated compound;
(B) a polymerizable compound containing an ethylenic unsaturated group; and
(C) a photopolymerization initiator.

A second aspect of the present invention is a flexible circuit board obtained by steps comprising: forming a photosensitive resin composition layer on a conductive circuit pattern by using a photosensitive resin composition of the above-mentioned first aspect and forming an insulating cover layer by developing the photosensitive resin composition with a specified pattern exposed.

To obtain a photosensitive resin composition capable of suppressing warpage occurrence after heat curing, the present inventors have compiled a series of studies. As a result, they focused upon a linear polymer containing a carboxyl group as a component used together with a polymerizable compound containing an ethylenic unsaturated group (component B). Among such a carboxyl-group containing linear polymer, where those having a glass transition temperature of not more than 55 °C obtained by addition polymerizing an ethylenic unsaturated compound are selectively used, good low-stress characteristics, solder temperature resistance, alkali developability and insulating properties can be obtained and also warpage occurrence caused by shrinkage in heat curing can be suppressed. Thus, they attained the present invention.

As mentioned above, the present invention relates to a photosensitive resin composition which contains the carboxyl-group containing a linear polymer having a glass transition temperature of not more than 55 °C obtained by addition polymerizing an ethylenic unsaturated compound (component (A)) and the polymerizable compound containing an ethylenic unsaturated group (component (B)). As a result, excellent effects such as suppressing the warpage occurrence are obtained. Accordingly, a highly reliable flexible circuit board can be obtained by forming a solder resist using the photosensitive resin composition of the present invention on a conductive circuit pattern so as to suppress warpage occurrence caused by shrinkage in heat curing during a production process of the flexible circuit board. Electronic components, such as an LSI, a diode, a transistor or a condenser are mounted on such a flexible circuit board for forming a mounting board, which is used for portable equipment such as a cellular phone.

When a phosphorated epoxy resin containing a phosphorous atom at not less than 2 % by weight based on a molecular weight thereof (component (D)) is used in addition to the above-mentioned components, flame retardance can be imparted with non-halogenation.

When the component (D) is present at 10 to 20 % by weight based on a total amount of nonvolatile component of the photosensitive resin composition, sufficient flame retardance and even further warpage-inhibition property can be obtained.

When the polymerizable compound (component (B)) is a bisphenol A based (meth)acrylate compound represented by the below-mentioned general formula (2), sensibility and alkali developability are excellent.

When the cyclic phosphazene compound (component (E)) is used, flame retardance can be improved without occurrence of warpage. Further, when the component (E) is used in combination with the component (D), compatibility of flame retardance with decreased warpage and solder resistance can be realized. However, the cyclic phosphazene compound (component (E)) is preferably present at not more than 20 % by weight based on a total amount of nonvolatile component of the photosensitive resin composition. When the component (E) is greater than 20 % by weight, crystals tend to deposit on a surface by blooming under high-temperature and high-humidity conditions.

### BRIEF DESCRIPTION OF THE DRAWINGS

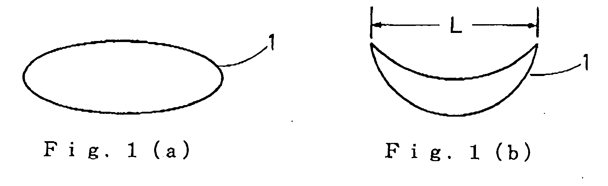

Figs. 1 (a) and Fig 1 (b) are explanatory views illustrating a method of measuring warpage according to the present invention.

### DETAILED DESCRIPTION OF THE INVENTION

Embodiments of the present invention will be described in detail in connection with the accompanying drawings.

The photosensitive resin composition of the present invention is obtained by using a specific linear polymer containing a carboxyl group obtained by addition polymerizing an ethylenic unsaturated compound (component (A)), a polymerizable compound containing ethylenic unsaturated group (component (B)) and a photopolymerization initiator (component (C)).

As the above-mentioned carboxyl-group containing linear polymer obtained by addition polymerizing an ethylenic unsaturated compound (component (A)), those having a glass transition temperature of not more than 55°C should be used. The glass transition temperature thereof is particularly preferably 30 to 55 °C . When the glass transition temperature is over 55 °C, warpage after curing shrinkage of the photosensitive resin composition tends to increase. When the glass transition temperature is less than 30 °C, workability tends to deteriorate with tackiness of dried coat after application of the photosensitive resin composition and drying thereof. Thus, according to the present invention, as the linear polymer containing carboxyl group obtained by addition polymerizing an ethylenic unsaturated compound (component (A)), those having glass transition temperature of not more than 55 °C are used. The glass transition temperature can be, for example, measured by the following method. The glass transition temperature (Tg) can be obtained by measuring tan θ under conditions of frequency of 1 Hz, a rate of temperature increase of 5°C/min., and measuring temperatures of 0 to 150 °C by means of rheometer, such as ARES available from TA Instruments, for measuring viscoelasticity.

The linear polymer containing the carboxyl group (component (A)) is an addition polymer of an ethylenic unsaturated compound and such a polymer can be obtained by copolymerizing (meth)acrylic acid, carboxyl-containing styrene derivative, maleic anhydride and the like. It is easy to design physical properties such as glass transition temperature (Tg) of the linear polymer obtained by this method, because an acid equivalent can be arbitrarily controlled and there are wide variety of raw material monomers.

The linear polymer containing the carboxyl group (component (A)) preferably has a weight-average molecular weight of 5, 000 to 100, 000, more preferably 6, 000 to 80, 000, particularly preferably 7,000 to 60,000. When the weight-average molecular weight is less than 5,000, physical properties such as solder temperature resistance tend to deteriorate. When the weight-average molecular weight is over 100,000, alkali developability tends to deteriorate.

The linear polymer containing the carboxyl group (component (A)) preferably has an acid equivalent of 200 to 900, more preferably 250 to 850, particularly preferably 300 to 800. When the acid equivalent is less than 200, oxidation of copper is promoted under high-temperature and high-humidity conditions, which is not preferred. When the acid equivalent is over 900, alkali developability tends to deteriorate.

Further, when an ethylenic unsaturated compound containing the (meth)acrylic acid is used as the carboxyl-group containing linear polymer (component (A)), it preferably includes, for example, phenoxyethyl (meth)acrylate as a copolymeric component for imparting heat resistance and a warpage-inhibition property.

Accordingly, examples of the carboxyl-group containing linear polymer (component (A)) include phenoxyethyl (meth)acrylate, polymers obtained by copolymerizing (meth)acrylic acid and another vinyl monomer. In the present invention, "(meth) acrylic" means acrylic or methacrylic and "(meth) acrylate" means acrylate or methacrylate, respectively.

As the another vinyl monomer, for example, (meth) acrylic acid alkyl ester, such as (meth) acrylic acid methyl ester, (meth)acrylic acid ethyl ester and (meth)acrylic acid butyl ester; 2-ethyl hexyl ester (meth)acrylate, (meth)acrylic acid tetrahydrofurfuryl ester, (meth)acrylic acid dimethylaminoethyl ester, (meth)acrylic acid diethylaminoethyl ester, styrene, α -styrene, vinyl toluene, N-vinyl pyrolidone, 2-hydroxyethyl(meth)acrylate, acrylamide, acrylonitrile, methacrylonitrile, N-phenyl maleimide and cyclohexyl maleimide, may be used either alone or in combination thereof.

The copolymerization amount of the phenoxyethyl (meth)acrylate as the above-mentioned copolymeric component is pre ferably20 to 92 % by weight, more preferably 30 to 90 % by weight, based on the total amount of the copolymeric component. When the copolymerization amount is less than 20 % by weight, frame retardance tends to deteriorate. When the copolymerization amount is over 92 % by weight, alkali developability of the cured solder resist tends to deteriorate.

The copolymerization amount of the (meth)acrylate as the above-mentioned copolymeric component is preferably 8 to 40 % by weight, more preferably 10 to 35 % by weight, based on the total amount of the copolymeric component. When the copolymerization amount is less than 8 % by weight, workability tends to deteriorate because the developing time is longer. When the copolymerization amount is over 40 % by weight, oxidation of copper as a circuit pattern is promoted under high-temperature and high-humidity conditions.

The copolymerization amount of the other vinyl monomer as the above-mentioned copolymeric component is preferably 0 to 72 % by weight, more preferably 0 to 60 % by weight, based on the total amount of the copolymeric component. When the copolymerization amount is over 72 % by weight, frame retardance and developability tend to deteriorate.

Further, an ethylenic unsaturated group or the like may be introduced into the linear polymer containing carboxyl group (component (A)) by a polymer reaction after polymerization. In the present invention, a value of glass transition temperature (Tg), as follows, in the case where the ethylenic unsaturated group is introduced by a polymer reaction means a measurement value of that before introduction of the ethylenic unsaturated group. When ethylenic unsaturated group is introduced into the carboxyl group of the copolymer obtained by using the above-mentioned monomers after polymerization by means of reaction with glycidyl acrylate or the like, it is preferred that the copolymerization amount of the (meth)acrylic acid is increased by considering the disappearing amount of the carboxyl group by the reaction after the introduction. The ethylenic unsaturated compound capable of introducing a carboxyl group into the linear polymer of the ethylenic unsaturated compound may not be limited to the above-mentioned (meth) acrylic acid. For example, a styrene derivative, maleic anhydride derivative or the like may be used.

A particularly preferable embodiment for obtaining the carboxyl-group containing linear polymer having a glass transition temperature of not more than 55 °C (component (A)) is as follows. Such a linear polymer can be obtained by reacting an ethylenic unsaturated compound having a glass transition temperature of not more than 30°C, an ethylenic unsaturated compound having a glass transition temperature of not less than 55 °C and (meth)acrylic acid under nitrogen gas stream, while delivering with a radical photopolymerization initiator such as azobis isobutylonitrile by drops into a solvent of 60 to 120°C.

The polymerizable compound containing an ethylenic unsaturated group (component (B)) to be used with the component (A) is not specifically limited, however, bisphenol A based (meth) acrylate compound represented by the following general formula (2) is preferred, because of an excellent balance among solder temperature resistance, alkali developability and so on. 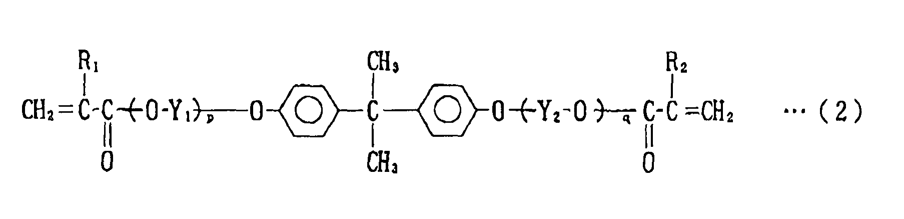 wherein R₁ and R₂ are a hydrogen atom or a methyl group, respectively, which may be the same or different from each other, Y₁ and Y₂ are alkylene groups having 2 to 6 carbon atoms, respectively, and p and q are positive numbers, respectively, selected in such a manner that a sum of p and q is 4 to 40.

Examples of the alkylene group having 2 to 6 carbon atoms of the above-mentioned formula (2) include an ethylene group, a propylene group, an isopropylene group, a butylene group, an isobutylene group, a pentylene group, a neopentylene group, a hexylene group, among which an ethylene group is preferred.

The isopropylene group is a group represented by -CH(CH₃)CH₂-. As coupling direction in -(O-Y₁)- and - (Y₂-O)- of the above-mentioned general formula (2), there are two cases : one case where the methylene group is coupled with oxygen; and the other case where the methylene group is not coupled with oxygen. Only one kind of direction may exist, or two kinds of directions may coexist.

The repetition unit of the above-mentioned -(O-Y₁)-and -(Y₂-O)- are two or more, two or more of Y₁ and two or more of Y₂ may be the same or different from each other. When Y₁ and Y₂ is composed of two or more of alkylene groups, two or more of -(O-Y₁)- and -(Y₂-O)- may exist at random or as a block.

On a position where two benzene rings can be substituted in the above-mentioned general formula (2), there may be one or more substituent groups. In the case where there are two or more substituent groups, they may be the same or different from each other. Examples of such a substituent group include an alkyl group having 1 to 20 carbon atoms, a cycloalkyl group having 3 to 10 carbon atoms, an aryl group having 6 to 14 carbon atoms, an amino group, a nitro group, a cyano group, a mercapto group, an allyl group, an alkylmercapto group having 1 to 10 carbon atoms, a hydroxy alkyl group having 1 to 20 carbon atoms, a carboxyl alkyl group having 1 to 10 carbon atoms of an alkyl group, an acyl group having 1 to 10 carbon atoms of an alkyl group, an alkoxy group having 1 to 20 carbon atoms, or a group having a heterocycle.

The repetition units p and q of the above-mentioned general formula (2) are positive numbers, respectively, selected in such a manner that a sum of p and q is 4 to 40, more preferably 4 to 15, particularly preferably 5 to 13. When the sum is less than 4, folding endurance tends to decrease. When the sum is over 40, insulating reliability tends to be inferior under high-temperature and high-humidity conditions because the total system of the photosensitive resin composition indicates hydrophilic property.

Examples of the bisphenol A based (meth)acrylate compound represented by the above-mentioned general formula (2) include 2,2'bis[4-(meth)acryloxydiethoxyphenyl] propane, 2,2'bis[4-(meth)acryloxytetraethoxyphenyl] propane, 2,2'bis[4-(meth)acryloxypentaethoxyphenyl] propane, 2,2'bis[4-(meth)acryloxydiethoxyoctapropoxyphenyl] propane and 2,2'bis[4-(meth)acryloxytriethoxyoctapxopoxyphenyl] propane, which may be used either alone or in combination.

Examples of the photopolymerization initiator (component (C)) used together with the components (A) and (B) include substituted or unsubstituted multinuclear quinones (such as 2-ethylanthraquinone, 2-t-butylanthraquinone, octamethylanthraquinone, 1,2-benzanthraquinone and 2,3-diphenylanthraquinone), α -ketaldonyl alcohols (such as benzoin and pivalon) , ethers, α-hydrocarbon-substituted aromatic acyloins (such as α -phenyl-benzoin and α , α -diethoxyacetophenones), aromatic ketones (such as benzophenone and 4,4'-bisdialkylaminobenzophenone, such as N,N'-tetraethyl-4,4'-diaminobenzophenone), thioxanthone compounds (such as 2-methylthioxanthone, 2,4-diethylthioxanthone, 2-chlorothioxanthone, 2-isopropylthioxanthone and 2-ethylthioxanthone), 2-methyl-1-[4-(methylthio)-phenyl] -morpholinopropane-1-one, which may be used either alone or in combination.

In addition to the components (A) to (C), a phosphorated epoxy resin containing a phosphorous atom at 2 % by weight based on the total molecular weight (component (D)) is preferably used for the photosensitive resin composition of the present invention. The component (D) works as a flame retardant and does not contain a halogen atom. Thus, environmental consciousness is taken into consideration with non-halogenation. Further, it is preferred because flame retardance is provided without deterioration of physical properties such as insulating reliability and developability.

When the content of the phosphorous atom is less than 2 % by weight, it is difficult to impart sufficient flame retardance. The content of the phosphorous atom is not specifically limited, compatibility with the epoxy resin may deteriorate when it is not less than 5 % by weight.

Examples of the component (D) include a flame-retardant phosphorated epoxy resin simultaneously containing a nitrogen atom and a phosphorous atom introduced in "Journal of Applied Polymer Science 73,353 (1999)" and a phosphorous-atom containing epoxy resin having a bisphenyl phosphate skeleton structure, which is represented by the following general formula (1). 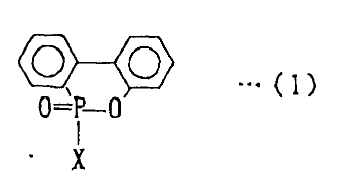 wherein X denotes an aromatic group having at least two substituent groups having a terminal epoxy group.

Examples of the aromatic group having at least two substituent groups each having a terminal epoxy group in the general formula (1), as X, include a novolak resin derivative and a bisphenol derivative, which may include multiple bisphenyl phosphate skeleton structures in each molecule.

Examples of phosphorated epoxy resin having a bisphenyl phosphate skeleton structure represented by the above-mentioned general formula (1) include an epoxy resin provided by Japanese Patent Nos. 3613724 and 3533973, and an epoxy resin having the following general formula (1a) provided by "Journal of Applied Polymer Science 73,1231 (1999).

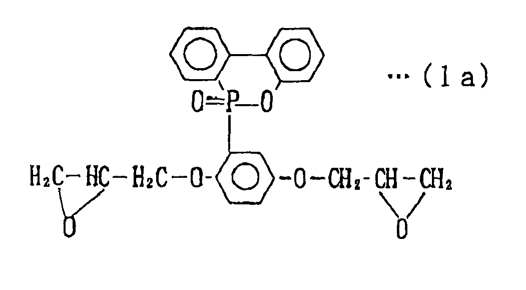

The phosphorated epoxy resin (component (D)) preferably has epoxy equivalent of 300 to 500 in terms of warpage caused by curing shrinkage and solder resistance. It is also preferred that the weight-average molecular weight is not more than 1,000.

To achieve compatibility among flame retardance, suppression of warpage and solder resistance, a cyclic phosphazene compound (component (E)) may be added to the components (A) to (D). Examples thereof include cyclic phenoxy phosphazene compound represented by the following general formula (3). 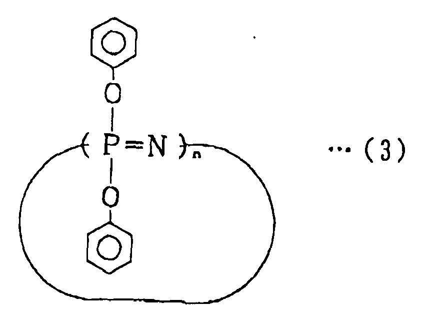 wherein n denotes a positive number of 3 to 10.

In the above-mentioned general formula (3), the repetitive unit n is preferably 3 to 10, more preferably 3 to 5.

Examples of cyclic phenoxy phosphazene compound represented by the above-mentioned general formula (3) include SPE-100 available from Otsuka Pharmaceutical Co., Ltd.

When the component (E) is further employed in addition to the components (A) to (D) for the photosensitive resin composition of the present invention, each content is preferably arranged as follows. The content of the component (A) is preferably 30 to 60 % by weight based on the total amount of the photosensitive resin composition. When the content is less than 30 % by weight, developing time is lengthened. When the content is over 60 % by weight, a film tends to remain on an exposed area in alkali development, and flame retardance tends to be insufficient.

The content of the component (B) is preferably 10 to 40 % by weight, more preferably 15 to 30 % by weight based on the total amount of the photosensitive resin composition. When the content is less than 10 % by weight, sensitivity in exposure to the photosensitive resin composition tends to deteriorate. When the content is over 40 % by weight, alkali developability tends to deteriorate.

The content of the component (C) is preferably 1 to 10 % by weight, more preferably 3 to 8 % by weight based on the total amount of the photosensitive resin composition. When the content is less than 1 % by weight, sensitivity in exposure to the photosensitive resin composition tends to deteriorate. When the content is over 10 % by weight, alkali developability tends to deteriorate.

The content of the component (D) is preferably 10 to 20 % by weight, more preferably 15 to 20 % by weight based on the total amount of nonvolatile component of the photosensitive resin composition. When the content is less than 10 % by weight, flame retardance tends to deteriorate. When the content is over 20 % by weight, warpage of the flexible circuit board tends to increase.

The content of the component (E) is preferably not more than 20 % by weight, more preferably 5 to 20 % by weight based on the total amount of the photosensitive resin composition. When the content is over 20 % by weight, the component (E) tends to deposit.

For the photosensitive resin composition of the present invention, appropriate additives may be incorporated, such as a pigment such as phthalocyanine green and phthalocyanine blue, a filler such as silica, barium sulfate and talc, an antifoaming agent, a leveling agent, a flame retardant other than the above component (D), a stabilizer, a tackifier such as 2-amino-5-mercapto-1,3,4-thiadiazole, 5-amino-1-H-tetrazole, an anti-rust agent such as benzotriazole, an a cross linking agent such as block isocyanate, which may be used either alone or in combination. These other additives are preferably used in the range of 0.01 to 20 % by weight based on the total amount of the photosensitive resin composition.

The photosensitive resin composition of the present invention can be obtained by mixing each component in such a manner that each component is present at a specified content. The photosensitive resin composition may include an organic solvent, as required. The organic solvent is not specifically limited, however, examples thereof include solvents or mixed solvents of diethylene glycol monoethyl ether acetate, diethylene glycol monobutyl ether acetate, diethylene glycol monoethyl ether, diethylene glycol monomethyl ether, solvent naphtha, N-methyl pyrolidone, γ-butyrolactone, butyl cellosolve, ethyl cellosolve, methyl cellosolve, toluene, xylene, mesitylene, acetone, methyl ethyl ketone and methyl isobutyl ketone.

When the organic solvent is used, the amount thereof is not specifically limited. It may be mixed at 0 to 200 parts by weight based on 100 parts by weight of the photosensitive resin composition.

The thus obtained photosensitive resin composition has preferably a storage elastic modulus of not more than 1GPa, more preferably of 0.1 to 1 GPa, at 50 °C after curing (being exposed to ultraviolet rays). When the storage elastic modulus is over 1 GPa, warpage after curing of the photosensitive resin composition tends to increase. The storage elastic modulus at 50 °C after curing (being exposed to ultraviolet rays) is obtained, for example, by reading a value at 50 °C when being measured under conditions of a frequency of 1 Hz, a rate of temperature increase of 5 °C/min., measuring temperatures of 0 to 150 °C, and tension mode by means of a solid viscoelastic modulus measuring device.

The photosensitive resin composition of the present invention is useful for a solder resist material of a flexible circuit board.

In the case where the photosensitive resin composition is used for the solder resist material of the flexible circuit board, it is used, for example, as follows, which will be described step by step.

First, the photosensitive resin composition of the present invention is coated on a surface where a conductive circuit pattern is formed by means of a screen print method, a spray method, a roll coat method or an electrostatic coating method in such a manner that a thickness of the photosensitive resin composition is 5 to 50 µm after being dried, is dried at 5 to 120 °C for 3 to 60 minutes, is arranged directly in contact or non-contact with a negative or positive mask pattern film, and is irradiated with an active light.

As a source of the active light, conventional light sources, for example, a carbon arc lamp, a mercury vapor arc lamp, an ultrahigh-pressure mercury lamp, a high-pressure mercury lamp, a xenon lamp and a metal hydride lamp, which irradiate effectively ultraviolet rays, may be used. Further, a photoflood lamp, a sunlamp and the like, which irradiate effectively visible light, may be also used.

Then, an unexposed portion is deleted using a developer such as an alkali solution by conventional methods such as a spray method, a rocking dipping method, a brushing method and a scrubbing method for development, and a resist pattern is produced.

Examples of the alkali solution include 0.1 to 5 % by weight dilute solution of sodium carbonate, 0.1 to 5 % by weight dilute solution of potassium carbonate, 0.1 to 5 % by weight dilute solution of sodium hydrate, 0.1 to 5 % by weight dilute solution of sodium tetraborate.

To improve solder resistance, chemical resistance and the like, UV irradiation by a high-pressure mercury lamp or heat treatment may be carried out, as required. The UV irradiation volume is preferably 0.2 to 10 J/cm² and the heat treatment is preferably about 100 to 180 °C for 15 to 120 minutes. The order of the UV irradiation and the heat treatment is irrelevant. The UV irradiation may precede the heat treatment or the heat treatment may precede the UV irradiation. Alternatively, either of the UV irradiation or the heat treatment may be conducted.

Electronic components, such as an LSI, a diode, a transistor or a condenser, are mounted on a flexible circuit board in which solder resist is formed in this manner for forming a mounting board, which is used for portable equipments such as a cellular phone.

The present invention will be further described in the following examples and comparative examples, but the present invention should not be construed as being limited thereto.

### EXAMPLES

### Synthetic method 1

### Synthesis of polymer (carboxyl-group containing linear polymer) a

First, 291 g of ethyl diglycol acetate (first input) was put into a 1-liter separable flask under nitrogen atmosphere and was heated to 130 °C with stirring. After keeping the heat on for 30 minutes, solution obtained by mixing 243 g of phenoxyethyl acrylate, 100 g of methacrylic acid, 158 g of methyl methacrylate, 158 g of ethyl diglycol acetate (second input), and 8.0 g of azobisisobutyronitrile as a catalyst, and dissolving thereof, was delivered by drops into the separable flask in 3 hours. After keeping the heat on for 2 hours at 80 °C, the solution was cooled. Thus, polymer a (solid concentration of 53 % by weight) was obtained.

### Synthesis of polymers (carboxyl-group containing linear polymer) b to e

The use amount of ethyl diglycol acetate (each input) was changed as shown in the following table 1. Also, each monomer component and its use amount were changed as shown in the following table 2. Further, "ARONIX" in the table 2 is N-acryloyl oxyethyl hexahydro phthalimide available from TOAGOSEI Co. , Ltd. Except for these changes, the polymers b to e were synthesized under the same conditions (temperature, time and so on) as the above Synthesis of polymera. Each glass transition temperature and each weight-average molecular weight of the thus obtained polymers a to e were measured in accordance with the following manners and their results are shown in the following table 2.

### Measurement of Glass Transition Temperature

The thus obtained polymer solutions were each coated on a polyethylene terephthalate film treated for mold release with silicone resin and dried at 120°C for 30 minutes in such a manner that the thickness after drying becomes about 20µm. After separating the thus obtained polymer film from the polyethylene terephthalate film, they were laminated and pressure-bonded by a roll laminator of 50 °C. The thus obtained film having about 300 µm was measured under conditions of a parallel plate of a diameter of 7.9 mm, a load of 200 g, a frequency of 6.3 rad/sec., a rate of temperature increase of 5 °C/min, and measuring temperatures of 0 to 150 °C by ARES available from TA Instruments. The glass transition temperature (Tg) was obtained from the thus obtained value tan θ.

### Measurement of weight-average molecular weight

Each weight-average molecular weight of the thus obtained polymers was measured under the following conditions.

Measurement apparatus: GPC (HLC-8120GPC available from TOSOH Corporation)
Column size: 6.0 mm (diameter) × 15 cm × 3 pieces (45 cm in total)
Column temperature: 40°C
Eluting solution: 10 ml (LiBr) + 10 ml (phosphoric acid/dimethylformamide (DMF))
Flow rate: 0.4 m/min
Inlet pressure: 4.7 Pa
Injection volume: 20µl
Detector: Refractometer index (RI)
Standard specimen: polyethylene oxide (PEO)

Data processing equipment: GPC-8020 available from TOSOH Corporation

**Table 1**

| | | | | | |
|---|---|---|---|---|---|
| (g) | | | | | |

| | Polymer | | | | |
|---|---|---|---|---|---|
| | a | b | c | d | e |
| First | 291 | 291 | 291 | 329 | 356 |
| Second | 158 | 152 | 158 | 171 | 186 |

**Table 2**

| | | | | | |
|---|---|---|---|---|---|
| (g) | | | | | |

| | Polymer | | | | |
|---|---|---|---|---|---|
| | a | b | c | d | e |
| Monomer component | | | | | |
| Phenoxyethyl acrylate | 243 (48.5) | - | 300 (60) | 200 (40) | 100 (20) |
| ARONIX | - | 375 (75) | - | - | - |
| methacrylic acid | 100 (20) | 100 (20) | 100 (20) | 100 (20) | 100 (20) |
| methyl methacrylate | 158 (31.5) | 25 (5) | 100 (20) | 200 (40) | 300 (60) |
| Solvent | | | | | |
| ethyl diglycol acetate | 449 | 443 | 449 | 500 | 542 |
| Glass transition temperature (°C) | 51 | 51 | 45 | 53 | 56 |
| Weight-average molecular weight | 23000 | 25000 | 19000 | 22000 | 22000 |

| | | | | | |
|---|---|---|---|---|---|
| *Each value shown in parenthesis is % by weight. | | | | | |

Next, each component shown below was prepared.

### Polymerizable compound containing ethylenic unsaturated group

B1: Ethylene oxide modified bisphenol A based methacrylate, BPE500 available from Shin-nakamura Chemical Co., Ltd. (in the above-mentioned general formula (2), p + q = 10, R₁ = H, R₂ = H, Y₁ = CH₂CH₂, Y₂ = CH₂CH₂).
B2: Trimethylolpropane triacrylate (TMPTA)

### Photopolymerization initiator

C1: IRGACURE 907 available from Ciba Geigy K.K.
C2: KAYACURE DETS-X available from Nippon Kayaku Co., Ltd.

### Phosphorated epoxy resin

D1: FX-305 (content of phosphorous atom: 3.0 % by weight, epoxy equivalent: 485) available from Tohto Kasei Co., Ltd.

D2: FX-305C (content of phosphorous atom: 2.6 % by weight, epoxy equivalent: 382) available from Tohto Kasei Co., Ltd.

### Epoxy resin

Triethylene glycol divinyl ether modified bisphenol A based epoxy resin available from Dainippon Ink and Chemicals, Incorporated.

### Cyclic phosphazene compound

SPE-100 (in the formula (3), n = 3 to 4) available from Otsuka Pharmaceutical Co., Ltd.

### Pigment

Phthalocyanine blue

### Tackifier

5-amino-1-H-tetrazole

### Antifoaming agent

MODAFLOW (acrylic-type copolymer) available from CBC Materials Co., Ltd.

### Examples 1 to 5 and Comparative Example

Each photosensitive resin composition was prepared by mixing each component at ratios shown in the following table 3 (in which each value in parenthesis is a volatile weight).

**Table 3**

| | | | | | | | |
|---|---|---|---|---|---|---|---|
| (g) | | | | | | | |

| | | EXAMPLE | | | | | COMPARATIVE EXAMPLE |
|---|---|---|---|---|---|---|---|
| | | 1 | 2 | 3 | 4 | 5 | |
| Polymer (A) | a | - | - | 40 | - | - | - |
| | b | 40 | - | - | - | 50 | - |
| | c | - | - | - | 30 | - | - |
| | d | - | 40 | - | - | - | - |
| | e | - | - | - | - | - | 40 |
| Polymerizable compound containing ethylenic unsaturated group (B) | B1 | 16 | 16 | 16 | 16 | 16 | 16 |
| | B2 | 2 | 2 | 2 | 2 | 2 | 2 |
| Photopolymerization initiator (C) | C1 | 2-5 | 2.5 | 2.5 | 2.5 | 2.5 | 2.5 |
| | C2 | 2.5 | 2.5 | 2.5 | 2.5 | 2.5 | 2.5 |
| Epoxy resin containing phosphorous atoms (D) | D1 | 17 | 17 | - | 17 | 17 | 17 |
| | D2 | - | - | - | - | - | - |
| Epoxy resin | | - | - | 17 | - | - | - |
| Cyclic phosphazene compound (E) | | 17 | 17 | 17 | 17 | 17 | 17 |
| Pigment | | 0.8 | 0.8 | 0.8 | 0.8 | 0.8 | 0.8 |
| Tackifier | | 0.2 | 0.2 | 0.2 | 0.2 | 0.2 | 0.2 |
| Antifoaming agent | | 1.0 | 1.0 | 1.0 | 1.0 | 1.0 | 1.0 |

The thus obtained photosensitive resin compositions were evaluated in accordance with the following characterization methods. These results are also shown in the following Table 4.

### Measurement of storage elastic modulus after curing

The photosensitive resin composition solution was coated on a surface of a polyethylene terephthalate film treated for mold release with silicone resin in such a manner that a thickness of the photosensitive resin composition was about 20 µm after being dried, was dried at 80 °C for 30 minutes. A polyethylene terephthalate cover film having a thickness of 38 µm is closely attached to the dried surface, and the surface thereof was exposed to a high-pressure mercury lamp at 300 mJ/cm². After separating the cover film, development was carried out by using 1 % by weight of sodium carbonate solution at 25 °C at a pressure of 0.2 MPa for 90 seconds, and then cleaning was carried out by tap water for 30 seconds. Then, heat treatment was carried out at 150 °C for 30 minutes by a circulating hot air drier. Thereafter, the treated polyethylene terephthalate film was separated, so that a specimen having a width of 5 mm, a thickness of about 20 µm and a length of 30 mm was produced. The tensile storage elastic modulus was measured by using the thus obtained specimen under conditions of measuring temperatures of 20 to 100 °C, a rate of temperature increase of 5 °C/min., a frequency of 1 Hz, and a chuck distance of 22. 6 mm by means of a solid viscoelastic modulus measuring device , RSA11, available f rom Rheometrics, Inc. Thevalue at 50 °C was regarded as the storage elastic modulus after curing.

### Warpage

The photosensitive resin composition solution was coated on a surface of a polyimide film having a thickness of 12. 5 µm in such a manner that a thickness of the photosensitive resin composition was 20 µm after being dried. Except for this, the same process as that of the above-mentioned measurement of storage elastic modulus was conducted to the drying process at 150 °C for 30 minutes, and thus the photosensitive resin composition film was formed on the polyimide film. Then, a circular specimen 1 having a diameter of 20 mm, as shown in Fig. 1 (a), was punched out. The minimum distance L between edges of the specimen 1 was measured and warpage of the film was determined by the following formula: [warpage (mm) = 20 (mm) - the minimum distance L (mm)]; and was evaluated in accordance with the following standard.
○ : warpage was less than 5 mm
×: warpage was not less than 5 mm

### Alkali developability

The photosensitive resin composition solution was coated on a defatted and soft-etched surface of a copper foil having a thickness of 35 µm in such a manner that a thickness of the photosensitive resin composition was 20 µm after being dried, and was dried at 80 °C for 30 minutes. A polyethylene terephthalate cover film having a thickness of 38 µm is closely attached to the dried surface, and the surface thereof was exposed to ultraviolet rays at 300 mJ/cm² by a high-pressure mercury lamp. After separating the cover film, development was carried out by using 1 % by weight of sodium carbonate solution at 25 °C and a pressure of 0.2 MPa for 90 seconds. The unexposed portion after development was visually observed and evaluated in accordance with the following standard.
○ : No remainder of the photosensitive resin composition was observed.
× : Any remainder of the photosensitive resin composition was observed.

### Flame retardance

The photosensitive resin composition solution was coated on a surface of a polyimide film having a thickness of 12.5 µm in such a manner that a thickness of the photosensitive resin composition was 20 µm after being dried, and was dried at 80 °C for 30 minutes. A polyethylene terephthalate cover film having a thickness of 38 µm is closely attached to the dried surface, and the surface thereof was exposed to ultraviolet rays at 300 mJ/cm² by a high-pressure mercury lamp of 250 W. In the meantime, the photosensitive resin composition solution was coated on the other surface of the polyimide film in such a manner that a thickness of the photosensitive resin composition was 20 µm after being dried, and was dried at 80 °C for 30 minutes. A polyethylene terephthalate cover film having a thickness of 38 µm was closely attached to the dried surface, and the surface thereof was exposed to ultraviolet rays at 300 mJ/cm² by the high-pressure mercury lamp of 250 W. After separating both polyethylene terephthalate cover films, development was carried out by using 1 % by weight of sodium carbonate solution at 25 °C and a pressure of 0.2 MPa for 90 seconds, and then cleaning was carried out by tap water for 30 seconds. Then, heat treatment was carried out at 150 °C for 30 minutes by a circulating hot air drier. The flame retardance was evaluated by a VTM method by means of HVUL UL combustion test chamber No. 1031 available from Toyo Seiki Seisaku-sho, Ltd. in conformity with the UL94 standard. VTM-0 was evaluated as passing status.

### Insulating reliability

A flexible wiring circuit, in which comb copper pattern having a thickness of 10 µm for a bias test of L/S (pattern width/pattern distance) = 50 µm/50 µm was directly formed on a polyimide film having a thickness of 25 µm, was prepared and the surface thereof was defatted and soft etched. Then, the photosensitive resin composition solution was coated on a surface of the flexible wiring circuit in such a manner that a thickness of the photosensitive resin composition was about 20 µm after being dried, and was dried at 80 °C for 30 minutes. A polyethylene terephthalate cover film having a thickness of 38 µm was closely attached to the dried surface, and the surface thereof was exposed to ultraviolet rays at 300 mJ/cm² by a high-pressure mercury lamp of 250 W. After separating the polyethylene terephthalate cover film, development was carried out by using 1 % by weight of sodium carbonate solution at 25 °C and a pressure of 0.2 MPa for 90 seconds. After cleaning was carried out by ion-exchanged water for 30 seconds, heat treatment was carried out at 150 °C for 30 minutes by a circulating hot air drier for obtaining a print circuit board specimen forinsulatingreliabilitytest. The specimen was put into a bath with constant temperature and humidity of 85°C and 85 %RH, and a voltage of 50 V was applied between comb-patterned electrodes, and insulating resistance was measured in the bath until 1000 hours had passed. The insulating reliability was evaluated in accordance with the following standard.
○ : Those indicating an insulating resistance value of not less than 10⁶ Ω after 1000 hours.
× : Those indicating an insulating resistance value of less than 10⁶ Ω within 1000 hours.

### Solder temperature resistance

A two-layer substrate having a thickness of 35 µ m (a copper foil having a thickness of 10 µm + a polyimide film having a thickness of 25 µm) was formed by using a copper foil having a thickness of 10 µm wherein the surface was defatted and soft-etched and a polyimide film having a thickness of 25 µm. The photosensitive resin composition solution was coated on a surface of the thus obtained two-layer film in such a manner that a thickness of the photosensitive resin composition was 20 µm after being dried, and was dried at 80 °C for 30 minutes. A polyethylene terephthalate cover film having a thickness of 38 µm was closely attached to the dried surface, and the surface thereof was exposed to ultraviolet rays through a glass mask wherein a negative pattern of a square of 5 mm was formed at 300 mJ/cm² by a high-pressure mercury lamp of 250 W. After separating the cover film, development was carried out by using 1 % by weight of sodium carbonate solution at 25 °C and a pressure of 0.2 MPa for 90 seconds. After cleaning was carried out by ion-exchanged water for 30 seconds, heat treatment was carried out at 150 °C for 30 minutes by a circulating hot air drier for obtaining a circuit board specimen for solder temperature resistance.

Then, after coating rosin flux MH-820V available from Tamura Kaken Corporation, the thus obtained specimen was dipped into a solder bath at 260°C for 10 seconds for soldering treatment. Then, visual observation was conducted in accordance with the following standard.
○ : No solder leaching, no solder resist float and no solder resist peeling occurred.
× : Solder leaching, solder resist float and solder resist peeling occurred.

**Table 4**

| | EXAMPLE | | | | | COMPARATIVE |
|---|---|---|---|---|---|---|
| | 1 | 2 | 3 | 4 | 5 | EXAMPLE |
| Storage elastic modulus (Gpa) | 0.7 | 1.0 | 0.7 | 0.7 | 0.5 | 1.5 |
| Warpage | ○ | ○ | ○ | ○ | ○ | × |
| Alkali developability | ○ | ○ | ○ | ○ | ○ | ○ |
| Flame retardance | VTM-0 | VTM-0 | Burning | VTM-0 | VTM-0 | VTM-0 |
| Insulating reliability | ○ | ○ | ○ | ○ | ○ | ○ |
| Solder temperature resistance | ○ | ○ | ○ | ○ | ○ | ○ |

From the above results, it is obvious that all Examples were good at all properties of alkali developability, insulating reliability and solder temperature resistance. Further, warpage was effectively suppressed in Examples. Still further, Examples containing the phosphorated epoxy resin as a flame retardant were good at flame retardance.

On the other hand, it is clear that an effect of suppressing the warpage occurrence could not obtained in Comparative Example because of increased warpage.

## Claims

1. A photosensitive resin composition for flexible circuit board comprising:
(A) a carboxyl-group containing linear polymer having a glass transition temperature of not more than 55 °C obtained by addition polymerizing an ethylenic unsaturated compound;
(B) a polymerizable compound containing an ethylenic unsaturated group; and
(C) a photopolymerization initiator.

2. The photosensitive resin composition according to claim 1, further comprising:
(D) a phosphorated epoxy resin containing a phosphorous atom at not less than 2 % by weight based on a molecular weight thereof.

3. The photosensitive resin composition according to claim 2, wherein said component (D) contains a bisphenyl phosphate skeleton structure represented by the following general formula (1): 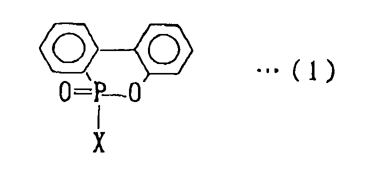 wherein X denotes an aromatic group having at least two substituent groups, each having a terminal epoxy group.

4. The photosensitive resin composition according to claim 2 or 3, wherein said component (D) is present at 10 to 20 % by weight based on a total amount of nonvolatile component of the photosensitive resin composition.

5. The photosensitive resin composition according to any one of claims 1 to 4, wherein said polymerizable compound (component (B)) is a bisphenol A based (meth)acrylate compound represented by the following general formula (2) : 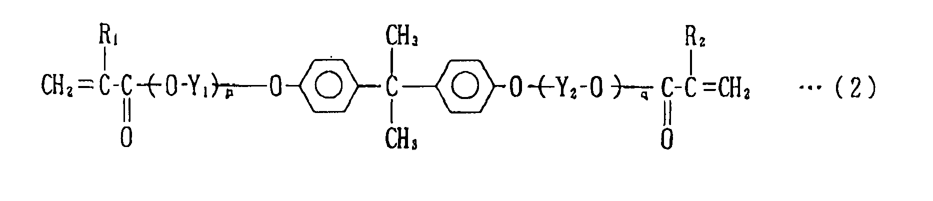 wherein R₁ and R₂ are a hydrogen atom or a methyl group, respectively, which may be the same or different from each other, Y₁ and Y₂ are alkylene groups having 2 to 6 carbon atoms, respectively, and p and q are positive numbers, respectively, selected in such a manner that a sum of p and q is 4 to 40.

6. The photosensitive resin composition according to any one of claims 1 to 5, further comprising:
(E) a cyclic phosphazene compound.

7. A flexible circuit board obtained by steps comprising:
forming a photosensitive resin composition layer on a conductive circuit pattern by using a photosensitive resin composition according to any one of claims 1 to 6, and
forming an insulating cover layer by developing the photosensitive resin composition layer with a specified pattern exposed.
